(19) Europäisches Patentamt
European Patent Office
Office européen des brevets

(11) EP 3 475 359 B1

(12) **EUROPÄISCHE PATENTSCHRIFT**

(45) Veröffentlichungstag und Bekanntmachung des Hinweises auf die Patenterteilung:
**07.07.2021 Patentblatt 2021/27**

(21) Anmeldenummer: **17728111.0**

(22) Anmeldetag: **30.05.2017**

(51) Int Cl.:
***C08J 5/18*** *(2006.01)*
***C08K 5/29*** *(2006.01)*
***C08L 67/02*** *(2006.01)*
***C08L 67/04*** *(2006.01)*
*C08L 79/00* *(2006.01)*

(86) Internationale Anmeldenummer:
**PCT/EP2017/062947**

(87) Internationale Veröffentlichungsnummer:
**WO 2017/220289 (28.12.2017 Gazette 2017/52)**

(54) **HYDROLYSESTABILE ZUSAMMENSETZUNGEN FÜR FOLIEN IN SOLARZELLEN**

HYDROLYSIS STABLE COMPOSITIONS FOR FILMS IN SOLAR CELLS

COMPOSITIONS STABLES À L'HYDROLYSE POUR FILMS DANS DES CELLULES SOLAIRES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.06.2016 EP 16175623**

(43) Veröffentlichungstag der Anmeldung:
**01.05.2019 Patentblatt 2019/18**

(73) Patentinhaber: **LANXESS Deutschland GmbH**
**50569 Köln (DE)**

(72) Erfinder: **LAUFER, Wilhelm**
**67158 Ellerstadt (DE)**

(56) Entgegenhaltungen:
**EP-A1- 2 262 000**
**EP-A1- 2 803 660**
**WO-A1-96/17011**
**WO-A1-2013/018679**
**WO-A1-2016/071347**
**DE-A1- 10 146 328**
**US-A1- 2013 303 651**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 475 359 B1

## Beschreibung

Die vorliegenden Erfindung betrifft neue hydrolysestabile Zusammensetzungen, insbesondere für Folien in Solarzellen, die sich durch eine verbesserte Hydrolysebeständigkeit auszeichnen, sowie die Solarzellen, enthaltend diese Folien.

Die Stromerzeugung mittels Photovoltaik hat nach dem beschlossenen deutschlandweiten Ausstieg aus der Kernenergie einen Aufschwung erfahren.

Bei der photovoltaischen Stromerzeugung wird bekanntermaßen Sonnenenergie mittels eines Siliziumzellen-Halbleiters direkt in elektrische Energie umgewandelt. Dieses Solarzellenelement erfährt allerdings eine Qualitätsminderung, wenn es in direkten Kontakt mit der Umgebungsluft gebracht wird. Darum wird ein Solarzellenelement im Allgemeinen zwischen einem Dichtungsmaterial und einem transparenten Oberflächenschutzmaterial (meistens Glas) und einem rückseitigen Oberflächenschutzmaterial (einer Rückseitenfolie zum Beispiel aus einem Polyesterharz, einem Fluorharz oder dergleichen) angeordnet, um eine Pufferwirkung zu erzielen und das Eindringen von Fremdkörpern und vor allem das Eindringen von Feuchtigkeit zu verhindern.

Fluorharze (Kunststoffe auf Basis von Polyvinylfluorid) eignen sich aufgrund ihrer Inertheit besonders für dieses Einsatzgebiet, allerdings sind diese so teuer in der Herstellung und häufig nicht in ausreichender Menge verfügbar, so das auf hydrolyseinstabile Polyesterharze ausgewichen wird. Die Entwicklungsarbeiten gehen daher vorrangig in Richtung Hydrolyseschutz der Polyesterharzschicht.

Zu diesem Zweck werden z.B. polymere Carbodiimide eingesetzt, die zahlenmittleren Molmassen von 2000 - 100000 aufweisen siehe EP-A 2262000. Dabei sind vor allem aliphatische Carbodiimide, wie z.B. Carbodilite® LA-1 bzw. Carbodilite® HMV-8CV, bevorzugt. Diese haben allerdings den Nachteil, ungenügend oder nur in hohen Konzentrationen als Hydrolyseschutzmittel zu wirken. Aromatischen Polycarbodiimide mit sehr hohen Molekularmassen, zeigen zwar einen guten Hydrolyseschutz in PET (siehe EP-A-2748234) jedoch nicht ausreichend in den biobasierten Kunstoffen wie z. B. Polylactiden (PLA) und sind aufgrund der aufwendigen Herstellung sehr teuer in der Anschaffung. Darüber hinaus führen deren Einsatz zu einer immer noch nicht zufriedenstellenden Emission von Isocyanaten, was eine großtechnische Herstellung von Folien ohne weiteres nicht möglich macht.

WO 2013/018679 lehrt, dass zur Herstellung von Folien mit hoher Bruchdehnung zwei Carbodiimide verwendet werden sollen und zwar eines mit einer zahlengemittelten Molmasse von 1000 bis 4000 und eines mit einer zahlengemittelten Molmasse über 18000.

Die Aufgabe der vorliegenden Erfindung bestand somit darin, Folien für Solarzellen auf Basis von Polyester bereitzustellen, die die Nachteile des Standes der Technik nicht aufweisen und vor allem kosteneffizient und hydrolysestabil sind.

Überraschenderweise wird diese Aufgabe gelöst durch Folien, enthaltend mindestens einen Polyester und mindestens ein polymeres Carbodiimid nach Formel (I)

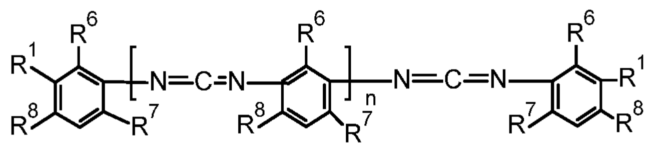

(I),

bei denen $R^1$ gleich oder verschieden sein können und ausgewählt ist aus der Gruppe der $NHCONHR^3$, $-NHCONR^3R^4$ oder $-NHCOOR^5$,

wobei $R^3$ und $R^4$ gleich oder verschieden sind und einen $C_1$-$C_{12}$-Alkyl-, $C_6$-$C_{12}$-Cycloalkyl-, $C_7$ - $C_{18}$ -Aralkylrest - oder Arylrest darstellen,

$R^5$ einem $C_1$-$C_{22}$-Alkyl-, $C_6$-$C_{12}$-Cycloalkyl-, $C_6$-$C_{18}$-Aryl oder $C_7$-$C_{18}$-Aralkylrest, sowie einem ungesättigten Alkylrest mit 2 - 22 Kohlenstoffatomen, bevorzugt 12-20, besonders bevorzugt 16-18 Kohlenstoffatomen, oder ein Alkoxypolyoxy-$C_1$-$C_{12}$-alkylenrest entspricht,

$R^6$, $R^7$ und $R^8$ jeweils unabhängig für Methyl- oder Ethyl steht, aber nur maximal einer der Reste $R^6$, $R^7$ und $R^8$ Methyl ist und n 1 bis 5 bedeutet mit einer zahlenmittleren Molmasse $M_n$ von > 1000 bis < 2000 g/mol, bestimmt mittels GPC, gemessen in Tetrahydrofuran (THF) gegen Polystyrol als Standard.

Gegenstand der vorliegenden Erfindung sind daher Folien enthaltend mindestens einen Polyester und mindestens ein polymeres Carbodiimid nach Formel (I)

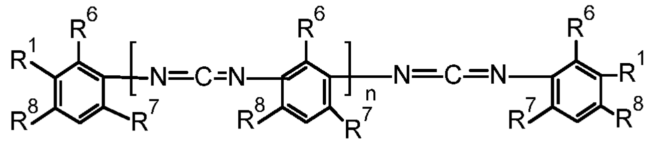

(I),

bei denen $R^1$ gleich oder verschieden sein können und ausgewählt ist aus der Gruppe der $NHCONHR^3$, $-NHCONR^3R^4$ oder $-NHCOOR^5$,

wobei $R^3$ und $R^4$ gleich oder verschieden sind und einen $C_1$-$C_{12}$-Alkyl-, $C_6$-$C_{12}$-Cycloalkyl-, $C_7$-$C_{18}$-Aralkylrest - oder Arylrest darstellen,

$R^5$ einem $C_1$-$C_{22}$-Alkyl-, $C_6$-$C_{12}$-Cycloalkyl-, $C_6$-$C_{18}$-Aryl oder $C_7$-$C_{18}$-Aralkylrest, sowie einem ungesättigten Alkylrest mit 2 - 22 Kohlenstoffatomen, bevorzugt 12-20, besonders bevorzugt 16-18 Kohlenstoffatomen, oder ein Alkoxypolyoxy-$C_1$-$C_{12}$-alkylenrest entspricht,

$R^6$, $R^7$ und $R^8$ jeweils unabhängig für Methyl- oder Ethyl steht, aber nur maximal einer der Reste $R^6$, $R^7$ und $R^8$ Methyl ist und n 1 bis 5 bedeutet mit einer zahlenmittleren Molmasse $M_n$ von > 1000 bis < 2000 g/mol, bestimmt mittels GPC, gemessen in Tetrahydrofuran (THF) gegen Polystyrol als Standard.

Ausgewertet wurden die Messungen der zahlenmittleren Molmasse mit einer Kombination von RI-Detektor (Brechungsindex und Viskositätsdetektor (universelle Kalibrierung).

In einer besonders bevorzugten Ausführungsform der Erfindung sind in dem polymeren aromatischen Carbodiimid der Formel (I) mit n = 3 und $R^1$ = $-NHCOOR^5$ mit $R^5$ = Cyclohexyl, und wobei $R^6$, $R^7$ und $R^8$ für Methyl- oder Ethyl steht, unter der Maßgabe, dass nur maximal einer der Reste $R^6$, $R^7$ und $R^8$ Methyl ist. Des Weiteren bevorzugt ist, dass es sich bei n = 3 um einen arithmetischen Mittelwert der Messungen handelt.

In einer Ausführungsform der Erfindung handelt es sich bei den bei für n in Formel (I) angegebenen Zahlenwerten um arithmetische Mittelwerte.

Die Ermittlung der zahlenmittleren Molmassen Mn erfolgte mittels GPC (Gel-Permeations-Chromatographie), gemessen in Tetrahydrofuran (THF) gegen Polystyrol als Standard. Ausgewertet wurde dies mit einer Kombination von RI-Detektor (Brechungsindex) und Viskositätsdetektor (universelle Kalibrierung). Die Kalibrierung mit Polystyrol erfolgte mit Referenz-Polystyrolen verschiedener Molmassen von der zertifizierten Firma PSS Polymer Standards Service GmbH.

Bei den polymeren Carbodiimiden im Sinne der Erfindung handelt es sich vorzugsweise um aromatische polymere Carbodiimide der Formel (I) mit einer zahlenmittleren Molmasse $M_n$ von > 1000 bis < 2000 g/mol. Diese sind handelsüblich und sind z. B. bei der Firma Rhein Chemie Rheinau GmbH erhältlich.

Der Carbodiimid-Gehalt (NCN-Gehalt, gemessen durch Titration mit Oxalsäure) der erfindungsgemäß eingesetzten Carbodiimide liegt vorzugsweise bei 2 - 12 Gew.%, bevorzugt 4 - 8 Gew.%, besonders bevorzugt bei 5 - 7 Gew.%.

In einer Ausführungsform der vorliegenden Erfindung handelt es sich bei dem Polyester um Polyethylenterephthalat (PET), Polyethylennaphthalat (PEN), Polybutylenterephthalat (PBT), Polytrimethyleneterephthalat (PTT) und/oder Polycyclohexandimethanol-terephthalat (PCT), esterbasierte thermoplastische Elastomere wie TPE-U oder TPE-E sowie biobasierte und/oder bioabbaubare bzw. kompostierbare Polyester wie z. B. Ecoflex der Fa. BASF, Polybutylenadipattherephthalat PBAT (Ecovio der Fa. BASF), Polylactide (PLA, z. B. der Natureworks oder Polyhydroxyalkoholate (PHA). Dabei sind Polyethylenterephthalat (PET), Polybutylenadipattherephthalat (PBAT) und Polylactid (PLA) besonders bevorzugt.

In einer weiteren Ausführungsform der Erfindung handelt es sich bei dem Polyester um ein Gemisch aus Polyestern. In diesem Zusammenhang ist ein Gemisch aus Polyethylenterephthalat (PET) und Polyethylennaphthalat (PEN) sowie ein Gemisch aus Polyethylenterephthalat (PET) und Polylactid (PLA) bevorzugt.

Bei den Polyestern handelt es sich um handelsüblich Substanzen, die z.B. bei den Firmen Invista, Novapet S. A., BASF, NatureWorks erhältlich sind.

Die Menge an polymerem Carbodiimid der Formel (I) beträgt, bezogen auf den Polyester, 0,5 - 2,5 Gew.%, bevorzugt 1,0 - 2,0 Gew.%.

Weiterer Gegenstand der vorliegenden Erfindung sind Folien, enthaltend die erfindungsgemäße Zusammensetzung.

Die erfindungsgemäßen Folien können auch weitere Additive enthalten, wie z.B. Pigmente, Farben, Füllstoffe, Stabilisatoren, Antioxidantien, Weichmacher, Verarbeitungshilfsstoffe, Vernetzer etc.

Die Herstellung der erfindungsgemäßen Folie erfolgt vorzugsweise nach dem folgenden Verfahren.

In einer Ausführungsform der Erfindung wird das polymere Carbodiimid der Formel (I) mit einer zahlenmittleren

Molmasse $M_n$ von > 1000 bis < 2000 g/mol in der gewünschten Konzentration mittels Kneter und/oder Extruder in den Polyester eingearbeitet.

Das polymere Carbodiimid der Formel (I) wird beispielsweise in Form eines Polyesterhaltigen Masterbatches mittels Kneter und/oder Extruder in den Polyester eingearbeitet. Dabei beträgt die Konzentration des Carbodiimids im Masterbatch vorzugsweise 10-20 Gew.%. Für die Herstellung sind vorzugsweise folgenden Geräte einsetzbar: Einwellen-, Doppelwellen- oder Mehrwellenextruder, Planetenextruder, Kaskadenextruder, kontinuierlich arbeitende Co-Kneter (Typ Buss) und diskontinuierlich arbeitende Kneter, z.B. Typ Banbury und andere in der Polymerindustrie übliche Aggregate.

Gegebenenfalls einzusetzenden Additive, Pigmente, Farben, Füllstoffe, Stabilisatoren, Antioxidantien, Weichmacher, Verarbeitungshilfsstoffe, Vernetzer werden vorzugsweise in einem Mischschritt mit dem polymeren Carbodiimid in den Polyester eingearbeitet. Die Dosierreihenfolge von Carbodiimid und Additiv kann dabei beliebig gewählt werden.

Die Herstellung der Folie erfolgt vorzugsweise durch Mischen von Carbodiimid oder Carbodiimid-Masterbatch und Polyester in Schmelze und anschließender Schmelzextrusion, siehe auch EP-A 2262000.

In einer bevorzugten Ausführungsform der Erfindung ist die Folie biaxial orientiert. In einer Ausführungsform der Erfindung wird die biaxial orientierte Folie hergestellt, indem eine dünne Schicht aus der erfindungsgemäßen geschmolzenen Zusammensetzung, beispielsweise mit PET als Polyester auf eine Walze aufgetragen wird, zuerst in Walzenrichtung und dann orthogonal zur Walzendrehrichtung gedehnt wird (BOPET).

In einer Ausführungsform der Erfindung wird die biaxial orientierte Folie auf einer BOPET-Maschine hergestellt, die um die Emission von giftigen Gasen während der Herstellung zu minimieren zum Teil oder vollständig abgeschlossen und/oder mit spezielle Ablufteinrichtungen versehen ist z. B. kommerziell erhältlich sind.

Die Folien können dabei in beliebiger Dicke hergestellt werden. Bevorzugt sind jedoch Schichtdicken zwischen 25 und 300 Mikrometer.

Gegenstand der vorliegenden Erfindung ist zudem die Verwendung der erfindungsgemäßen Folien in Solarzellen und dort vorzugsweise zum Abdichten und damit zum Schutz vor Umgebungseinflüssen, wie z.B. Feuchtigkeit und dem Eindringen von Fremdkörpern.

Gegenstand der vorliegenden Erfindung ist zudem ein Solarzellenmodul, enthaltend mindestens eine erfindungsgemäße Folie, vorzugsweise als Rückseitenabdeckung.

Solarzellen bestehen in der Regel aus mehreren Schichten aus unterschiedlichen Materialien, wie

- dem Frontglas, aus z.B. Glasscheiben oder transparenten Substraten, wie z.B. Polycarbonat,
- den Siliciumwafern, die einlaminiert sind in Einbettfolien, bestehend in der Regel in Ethylenvinylacetat,
- einer Rückseitenfolie aus Polyvinylfluorid und/oder Polyester und
- einem Aluminiumrahmen.

Zudem sind auch Solarzellen bekannt, in denen sich zwischen dem Frontglas und dem Siliciumwafer noch transparente Polymerschichten befinden, z.B. aus $\alpha$-Olefin-Vinylacetat-Copolymeren, mit Olefinen, ausgewählt aus Ethen, Propen, Buten, Penten, Hexen, Hepten und Octen, wie z.B. beschrieben in EP-A 2031662.

In der vorliegenden Erfindung wird die erfindungsgemäße Folie in Solarzellen als Rückseitenfolie eingesetzt. Dabei ist die Folie in allen im Stand der Technik bekannten Solarzellen einsetzbar.

Die Herstellung der Solarzelle erfolgt dabei nach den in dem Stand der Technik beschriebenen Verfahren, ausgehend von den Standardverfahren zur Herstellung von Silizium über Gießverfahren, Bridgeman Verfahren, EFG (edgedefined film-fed growth)-Verfahren oder dem Czochralski-Verfahren und der nachfolgenden Herstellung der Si-Wafer und dem Aufeinanderschichten der vorgenannten Materialschichten, wobei anstelle der standardmäßig eingesetzten Rückseitenfolie, die erfindungsgemäße Folie eingesetzt wird. Die einzelnen Schichten der Solarzelle können dabei auch in Laminierverfahren miteinander verbunden werden, siehe EP-A 2031662.

Der Rahmen der Erfindung erfasst alle oben stehenden und im Folgenden aufgeführten allgemeinen oder in Vorzugsbereichen genannten Restedefinitionen, Indizes, Parameter und Erläuterungen untereinander, also auch zwischen den jeweiligen Bereichen und Vorzugsbereichen in beliebiger Kombination.

Die nachfolgenden Beispiele dienen der Erläuterung der Erfindung, ohne dabei limitierend zu wirken.

**Ausführungsbeispiele:**

In den Beispielen wurden die folgenden Substanzen eingesetzt:

**PET** = Polyethylenterephthalat der Firma Invista, eingesetzt in den Beispielen 1 bis 5.

**PLA** = Polylactid (Polymilchsäure) der Fa. NatureWorks in den Beispielen 6 bis 16.

In den Bsp. Nr. 2 und 7 wurde das zuvor genannten PET bzw. PLA in einem Labordoppelschneckenextruder ZSK 25 der Firma Werner & Pfleiderer vor der unten beschriebenen Messung einmal extrudiert.

**CDI 1 (Vergleich)** = Bis-2,6-Diisopropylphenylcarbodiimid, ein monomeres aromatisches Carbodiimid mit einer zahlenmittleren Molmasse von Mn = 270 g/mol, und einem NCN-Gehalt von ca. 11 Gew.%, eingesetzt in den Beispielen 3, 8 und 13.

**CDI 2 (Vergleich)** = Ein polymeres aromatisches Carbodiimid der Formel $R^{10}$-$R^9$-(-N=C=N-$R^9$-$)_m$-$R^{10}$ mit $R^9$ = Triisopropylphenylen und $R^{10}$ = -NCN$R^9$ ist mit einer zahlenmittleren Molmasse von Mn = 1700 g/mol, und einem NCN-Gehalt von ca. 13 Gew.%, eingesetzt in den Beispielen 4, 9 und 14.

**CDI 3 (Vergleich)** = Ein polymeres aromatisches Carbodiimid der der Formel $R^{11}$-$R^9$-(-N=C=N-$R^9$-$)_m$-$R^{11}$ mit $R^9$ = Triisopropylphenylen und $R^{11}$ = -NCO ist mit einer zahlenmittleren Molmasse von ca. Mn = 5700 g/mol, und einem NCN-Gehalt von ca. 13,5 Gew.%, eingesetzt in den Beispielen 10 und 15.

**CDI 4 (erfindungsgemäß)** = polymeres aromatisches Carbodiimid der Formel (I) mit n = 3 als arithmetisches Mittelwert und $R^1$ = -NHCOO$R^5$ mit $R^5$ = Cyclohexyl, und $R^6$, $R^7$ = Ethyl und $R^8$ = Methyl- , mit einer zahlenmittlere Molmasse: ca. 1400 g/mol, und einem NCN-Gehalt von ca. 11 Gew.%, eingesetzt in den Beispielen 5, 11 und 16.

**CDI 5 (Vergleich)** = polymeres aromatisches Carbodiimid der Formel (I) mit n = 2 - 3 als arithmetisches Mittelwert und $R^1$ = -NHCOO$R^5$ mit $R^5$ = Cyclohexyl, und $R^6$, $R^7$ = Ethyl und $R^8$ = Methyl- , mit einer zahlenmittlere Molmasse: ca. 790 g/mol, und einem NCN-Gehalt von ca. 11 Gew.%, eingesetzt in den Beispielen 5, 11 und 16.

**CDI 6 (Vergleich)=** polymeres aromatisches Carbodiimid der Formel (I) mit n = 3 - 4 als arithmetisches Mittelwert und $R^1$ = -NHCOO$R^5$ mit $R^5$ = Cyclohexyl, und $R^6$, $R^7$ = Ethyl und $R^8$ = Methyl- , mit einer zahlenmittlere Molmasse: ca. 2180 g/mol, und einem NCN-Gehalt von ca. 11 Gew.%, eingesetzt in den Beispielen 5, 11 und 16.

Die Einarbeitung der Carbodiimide in das PET und das PLA erfolgte mittels eines Labordoppelschneckenextruders ZSK 25 der Firma Werner & Pfleiderer.

Art und Menge des eingesetzten Carbodiimids ergeben sich aus Tabelle 1, ebenso wie die Messergebnisse in Bezug auf die Hydrolysestabilität.

Die für die Messung der Bruchdehnung verwendeten F3-Normprüfkörper wurden an einer Spritzgießmaschine des Typs Arburg Allrounder 320 S 150 - 500 erstellt.

Für den Hydrolysetest wurden diese F3-Normprüfkörper im Fall von PET bei einer Temperatur von 110°C in Wasserdampf und im Fall von PLA bei 65°C in Wasser für mehrere Tage gelagert und deren Bruchdehnung nach 0, 1, 3 und 5 Tagen im Fall von PET und 0, 1, 2, 3 und 6 Tagen im Fall von PLA gemessen.

Die Ermittlung der zahlenmittleren Molmassen erfolgte mittels GPC (Gel-Permeations-Chromatographie), gemessen in THF gegen Polystyrol als Standard, ausgewertet mit einer Kombination von RI-Detektor (Brechungsindex) und Viskositätsdetektor (universelle Kalibrierung). Zu diesem Zweck wurde ein Messgerät der Firma Thermo Scientific eingesetzt. Die Kalibrierung mit Polystyrol erfolgte mit Referenz-Polystyrolen verschiedener Molmassen von der zertifizierten Firma PSS Polymer Standards Service GmbH.

Die in Tabelle 1 und 2 angegebenen Werte für die Bruchdehnung ergeben sich aus der folgenden Berechnung:

$$\text{Bruchdehnung [\%]} = (\text{Bruchdehnung nach X Tagen} / \text{Bruchdehnung nach 0 Tagen}) \times 100$$

**Tabelle 1**

| **Bsp. Nr** | **1** | **2** | **3** | **4** | **5** |
|---|---|---|---|---|---|
| | V | V | V | V | E |
| **Menge CDI** [%] | 0 | 0 | 1,5 | 1,5 | 1,5 |
| **CDI** | - | - | **CDI 1** | **CDI 2** | **CDI 4** |
| **Bruchdehnung** [%] **(X = 1 Tag)** | 80 | 69 | 100 | 88 | 100 |

(fortgesetzt)

| Bsp. Nr | 1 | 2 | 3 | 4 | 5 |
|---|---|---|---|---|---|
| **Bruchdehnung** [%] **(X= 3 Tage)** | 30 | 0 | 61 | 37 | 95 |
| **Bruchdehnung** [%] **(X = 5 Tage)** | 0 | 0 | 40 | 0 | 52 |
| V = Vergleichsversuch, E = erfindungsgemäß | | | | | |

**Tabelle 2**

| Bsp. Nr | 6 | 7 | 8 | 9 | 10 | 11 |
|---|---|---|---|---|---|---|
| | V | V | V | V | V | E |
| **Menge CDI** [%] | 0 | 0 | 1,5 | 1,5 | 1,5 | 1,5 |
| **CDI** | - | - | **CDI 1** | **CDI 2** | **CDI 3** | **CDI 4** |
| **Bruchdehnung** [%] **(X = 1 Tag)** | 64 | 55 | 100 | 100 | 100 | 100 |
| **Bruchdehnung** [%] **(X= 2 Tage)** | 12 | 0 | 100 | 100 | 90 | 100 |
| **Bruchdehnung** [%] **(X= 3 Tage)** | 0 | 0 | 61 | 100 | 28 | 100 |
| **Bruchdehnung** [%] **(X= 6 Tage)** | 0 | 0 | 0 | 0 | 0 | 89 |
| V = Vergleichsversuch, E = erfindungsgemäß | | | | | | |

Es zeigt sich, dass bei der Verwendung der erfindungsgemäßen Carbodiimide trotz der niedrigen zahlenmittleren Molmasse die höchste Hydrolysestabilität erreicht werden kann.

Messung der Emission (Off-gassing)

Die Abluftmessung zur Ermittlung der Isocyanat-Emission erfolgte während der Einarbeitung der Carbodiimide in das Polylactid (PLA) mittels eines Labordoppelschneckenextruders ZSK 25 der Firma Werner & Pfleiderer.

Dazu wurde ein Teil des Abluftstromes direkt an der Düse mit 2l/min für 30 min über ein mit Derivatisierungsmittel imprägniertes Röhrchen geleitet. Die Isocyanatmenge wurde dann mittels HPLC bestimmt (Doppelbestimmung).

In der Tabelle 3 sind die Emissionswerte beim Einsatz der verschiedenen Carbodiimide zusammengefasst:

**Tabelle 3**

| Bsp. Nr | 12 | 13 | 14 | 15 | 16 |
|---|---|---|---|---|---|
| | V | V | V | V | E |
| **Menge CDI** [%] | 0 | 1,5 | 1,5 | 1,5 | 1,5 |
| **CDI** | - | **CDI 1** | **CDI 2** | **CDI 3** | **CDI 4** |
| **IsocyanatKonzentration [ppm]** | - | 3440/3450 | 960/950 | 480/480 | 240/230 |

Es zeigt sich, dass die polymeren Carbodiimide aus der erfindungsgemäßen Zusammensetzung ein extrem verbessertes Emissionsverhalten zeigen.

Der Einfluss des zahlenmittleren Molekulargewichtes auf die Verarbeitbarkeit und dessen Eigenschaften bei der Folienherstellung wird aus der nachstehenden Tabelle 4 ersichtlich.

**Tabelle 4**

| CDI | Mn | Pastillierberkeit | Folienherstellung |
|---|---|---|---|
| CDI 5 (V)) | 790 g / mol | nicht pastillierbar, weich, klebrig | sehr gut, homogene Folie, transparent |
| CDI 4 | 1400 g/ mol | sehr gut, spröde | gut, homogene Folie, transparent |
| CDI 6 (V) | 2180 g /mol | gut, spröde, geringfügig Fäden gezogen | nicht homogene Folie, Schleier-Bildung |

Nur das erfindungsgemäße Carbodiimid mit einem zahlenmittleren Molekulargewicht zwischen 1000 und 2000 g/mol zeigt eine sehr gute Pastillierbarkeit und liefert homogen und transparente Folien.

## Patentansprüche

1. Folie, enthaltend mindestens einen Polyester und bezogen auf den Polyester 0,5 - 2,5 Gew.%, vorzugsweise 1,0 - 2,0 Gew.% mindestens eines polymeren Carbodiimids nach Formel (I)

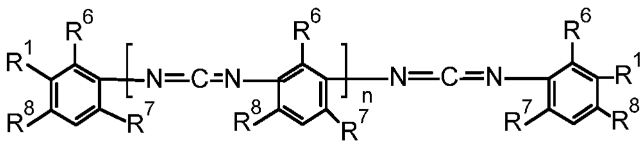
(I)

bei dem die Reste $R^1$ gleich oder verschieden sein können und ausgewählt sind aus der Gruppe der $NHCONHR^3$, $-NHCONR^3R^4$ oder $-NHCOOR^5$,
wobei $R^3$ und $R^4$ gleich oder verschieden sind und einen $C_1$-$C_{12}$-Alkyl-, $C_6$-$C_{12}$-Cycloalkyl-, $C_7$ - $C_{18}$ -Aralkylrest - oder Arylrest darstellen,
$R^5$ einem $C_1$ - $C_{22}$ - Alkyl-, $C_6$ - $C_{12}$ -Cycloalkyl-, $C_6$ - $C_{18}$ -Aryl oder $C_7$ - $C_{18}$-Aralkylrest, sowie einem ungesättigten Alkylrest mit 2 - 22, bevorzugt 12-20, besonders bevorzugt 16-18 Kohlenstoffatomen, oder ein Alkoxypolyoxy-$C_1$-$C_{12}$-alkylenrest entspricht,
$R^6$, $R^7$ und $R^8$ jeweils unabhängig für Methyl- oder Ethyl steht, aber nur maximal einer der Reste $R^6$, $R^7$ und $R^8$ Methyl ist und n 1 bis 5 bedeutet,
mit einer zahlenmittleren Molmasse $M_n$ von > 1000 bis < 2000 g/mol, bestimmt mittels GPC, gemessen in Tetrahydrofuran (THF) gegen Polystyrol als Standard.

2. Folie nach Anspruch 1, **dadurch gekennzeichnet, dass** es sich bei dem Polyester um Polyethylenterephthalat (PET), Polyethylennaphthalat (PEN), Polybutylenterephthalat (PBT), Polytrimethyleneterephthalat (PTT) und/oder Polycyclohexandimethanol-terephthalat (PCT), esterbasierte thermoplastische Elastomere bevorzugt TPE-U oder TPE-E, biobasierte und/oder bioabbaubare bzw. kompostierbare Polyester vorzugsweise Polybutylenadipattherephthalat PBAT, Polylactide (PLA) oder Polyhydroxyalkoholate (PHA) handelt.

3. Folie nach Anspruch 1 oder 2, **dadurch gekennzeichnet, dass** diese biaxial orientiert ist.

4. Solarzellenmodul, enthaltend mindestens eine Folie nach Anspruch 1 oder 2, vorzugsweise als Rückseitenabdeckung.

5. Verwendung einer Folie nach einem der Ansprüche 1 bis 3 zum Abdichten einer Solarzelle.

## Claims

1. Film comprising at least one polyester and, based on the polyester, 0.5 - 2.5% by weight, preferably 1.0 - 2.0% by weight of at least one polymeric carbodiimide according to formula (I)

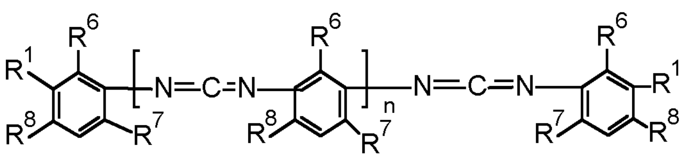
(I),

in which the radicals $R^1$ may be identical or different and are selected from the group comprising $NHCONHR^3$, $-NHCONR^3R^4$ or $-NHCOOR^5$ ,
wherein $R^3$ and $R^4$ are identical or different and represent a $C_1$-$C_{12}$-alkyl, $C_6$-$C_{12}$-cycloalkyl, $C_7$-$C_{18}$-aralkyl radical or aryl radical,
$R^5$ corresponds to a $C_1$-$C_{22}$-alkyl, $C_6$-$C_{12}$cycloalkyl, $C_6$-$C_{18}$-aryl or $C_7$-$C_{18}$-aralkyl radical, and an unsaturated

alkyl radical having 2-22, preferably 12-20, particularly preferably 16-18 carbon atoms, or an alkoxypolyoxy-$C_1$-$C_{12}$-alkylene radical,
$R^6$, $R^7$ and $R^8$ are each independently methyl or ethyl, but only a maximum of one of the radicals $R^6$, $R^7$ and $R^8$ is methyl and n is 1 to 5,
having a number-average molar mass $M_n$ of > 1000 to < 2000 g/mol, determined by means of GPC, measured in tetrahydrofuran (THF) against polystyrene as standard.

2. Film according to Claim 1, **characterized in that** the polyester is polyethylene terephthalate (PET), polyethylene naphthalate (PEN), polybutylene terephthalate (PBT), polytrimethylene terephthalate (PTT) and/or polycyclohexanedimethanol terephthalate (PCT), ester-based thermoplastic elastomers, preferably TPE-U or TPE-E, biobased and/or biodegradable or compostable polyesters, preferably polybutylene adipate therephthalate PBAT, polylactides (PLA) or polyhydroxyalkoxides (PHA).

3. Film according to Claim 1 or 2, **characterized in that** said film is biaxially oriented.

4. Solar cell module comprising at least one film according to Claim 1 or 2, preferably as backing cover.

5. Use of a film according to any of Claims 1 to 3 for sealing a solar cell.

## Revendications

1. Feuille, contenant au moins un polyester et, par rapport au polyester, 0,5 à 2,5 % en poids, de préférence 1,0 à 2,0 % en poids d'au moins un carbodiimide polymérique selon la formule (I)

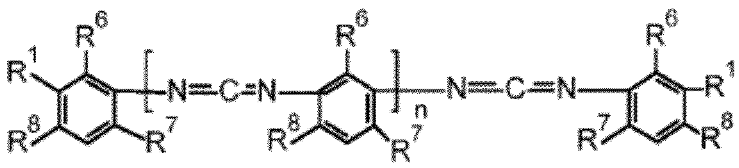

(I)

dans laquelle les radicaux $R^1$ peuvent être identiques ou différents et sont choisis dans le groupe de $NHCONHR^3$, $-NHCONR^3R^4$ et $-NHCOOR^5$,
$R^3$ et $R^4$ étant identiques ou différents et représentant un radical $C_{1-12}$-alkyle, un radical $C_{6-12}$-cycloalkyle, un radical $C_{7-18}$-arylkyle ou un radical aryle,
$R^5$ correspond à un radical $C_{1-22}$-alkyle, un radical $C_{6-12}$-cycloalkyle, un radical $C_{6-18}$-aryle ou un radical $C_{7-18}$-aralkyle, ainsi qu'à un radical alkyle insaturé comportant 2 à 22, préférablement 12 à 20, particulièrement préférablement 16 à 18 atomes de carbone, ou à un radical alcoxypolyoxy-$C_{1-12}$-alkylène,
$R^6$, $R^7$ et $R^8$ représentent à chaque fois indépendamment méthyle ou éthyle, mais seulement au maximum un des radicaux $R^6$, $R^7$ et $R^8$ est méthyle et n signifie 1 à 5,
doté d'une masse molaire moyenne en nombre $M_n$ de > 1 000 à < 2 000 g/mole, déterminée au moyen d'une CPG, mesurée dans le tétrahydrofuranne (THF) par rapport à un polystyrène comme référence.

2. Feuille selon la revendication 1, **caractérisée en ce que** le polyester est un poly(téréphtalate d'éthylène) (PET), un poly(naphtalate d'éthylène) (PEN), un poly(téréphtalate de butylène) (PBT), un poly(téréphtalate de triméthylène) (PTT) et/ou un poly(téréphtalate de cyclohexanediméthanol) (PCT), des élastomères thermoplastiques à base d'ester préférablement un TPE-U ou un TPE-E, des polyesters à base biologique et/ou biodégradables ou compostables de préférence un poly(téréphtalate adipate de butylène) PBAT, des polylactides (PLA) ou des polyhydroxyalcoolates (PHA).

3. Feuille selon la revendication 1 ou 2, **caractérisée en ce que** celle-ci est orientée de manière biaxiale.

4. Module de cellule solaire, contenant au moins une feuille selon la revendication 1 ou 2, de préférence en tant que couverture de face arrière.

5. Utilisation d'une feuille selon l'une quelconque des revendications 1 à 3 pour l'étanchéification d'une cellule solaire.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 2262000 A
- EP 2748234 A
- WO 2013018679 A
- EP 2031662 A